# EUROPEAN PATENT APPLICATION

(11) **EP 4 567 799 A1**
(43) Date of publication of application: **11.06.2025**
(21) Application number: 23215153.0
(22) Date of filing: 08.12.2023
(51) Int. Cl.: G11C 5/02, G11C 5/06, G11C 7/18, G11C 8/08, G11C 8/14, G11C 8/12, G11C 11/408, G11C 11/4091, G11C 11/4097, H10B 12/00

(54) **A 3D DRAM WITH VERTICAL WORD LINES**

(71) Applicant: IMEC VZW, 3001 Leuven (BE); Katholieke Universiteit Leuven KU Leuven Research & Development, 3000 Leuven (BE)
(72) Inventor: Wang, Bowen, 3001 Leuven (BE); Oh, Hyungrock, 1200 Brussels (BE); Gupta, Mohit, 3001 Heverlee (BE)
(74) Representative: Roth, Sebastian

(57) **Abstract**

The present disclosure relates to a 3D DRAM. The DRAM comprises a block with a 3D array of memory cells. The block comprises multiple planes stacked along a first axis, each plane comprising a 2D array of memory cells organized in rows extending along a second axis perpendicular to the first axis and columns extending along a third axis perpendicular to the first and the second axis. The block is divided into multiple sub-blocks arranged along the second axis, each sub-block containing one column of memory cells of each plane. The DRAM further comprising a plurality of bit lines, wherein each bit line extends along the third axis in one of the planes and is connected to one column of memory cells in that plane, or wherein each bit line extends in one of the planes along the second axis and is connected to one memory cell in each sub-block. The DRAM further comprises a plurality of global bit lines, wherein the global bit lines are connected to the bit lines in each sub-block. The DRAM further comprises a plurality of sense amplifiers, wherein each sense amplifier is connected to one of the global bit lines.

## Description

### TECHNICAL FIELD

The present disclosure relates to dynamic random access memory (DRAM). In particular, this disclosure proposes a 3D DRAM, that is, a DRAM with a 3D array of memory cells. The 3D DRAM of this disclosure comprises vertical word lines.

### BACKGROUND

Currently, there are difficulties in making DRAM smaller while increasing its storage capacity. In particular, DRAM scaling is facing challenges in terms of reducing the memory cell area, increasing the memory cell density, and achieving higher aspect ratios in the vertical direction of the memory cell. There have been various approaches for creating 3D DRAM to address these difficulties. However, most of these conventional approaches concentrate only on the individual memory bit cells and their organization into a memory cell array, while not considering the connections between the memory cells and the core circuits, like sense amplifiers and word line drivers.

A first challenge arises from a size discrepancy between the smaller bit line pitch (BLP) and the larger bit line sense amplifier (BLSA). For example, for advanced DRAM technology, the BLP is about ~3.4F (44nm), while the area of a BLSA is estimated to be 284F2 (88nm by 6.25µm). For a 2D DRAM, one BLSA can be located between two BLPs, on either side of an array block (MAT). In this setup, multiple BLSAs are arranged similarly to the bit lines in one direction (either x-direction or y-direction). However, for a 3D DRAM, the bit lines are arranged in two directions (in both x-direction and y-direction), which restricts the placement and routing of the BLSAs. This affects the performance and area efficiency of the 3D DRAM.

A second challenge arises from the number of BLSAs. For a 2D DRAM, each bit line is connected to a BLSA, and all the memory cells on a word line operate simultaneously by word line activation. In other words, there should be an equal number of BLSAs and bit lines in the MAT, which leads to an increased area consumption. Transferring this kind of configuration (i.e., one bit line to one BLSA) to a 3D DRAM is problematic, because it brings about issues with the placement and connection to the BLSA, and also leads to a larger area consumption.

### SUMMARY

Therefore, an objective of this disclosure is to provide an improved 3D DRAM. In particular, an objective is to reduce the area consumption in view of the above-described issues. Another objective is to reduce the parasitic bit line loading in the 3D DRAM. Another objective is to reduce the number of word line drivers in the 3D DRAM. To this end, the disclosure has the objective to provide both a 3D DRAM memory cell array architecture, and a way to connect the 3D DRAM memory cell array to the sense amplifiers and word line drivers, respectively. Thereby, the disclosure aims for a one transistor and one capacitor (1T1C) memory cell configuration.

These and other objectives are achieved by the solutions of this disclosure as described in the independent claims. Advantageous implementations of these solutions are described in the dependent claims.

A first aspect provides a DRAM comprising: a block comprising a 3D array of memory cells; wherein the block comprises multiple planes stacked along a first axis, each plane comprising a 2D array of memory cells organized in rows extending along a second axis perpendicular to the first axis and columns extending along a third axis perpendicular to the first and the second axis; and wherein the block is divided into multiple sub-blocks arranged along the second axis, each sub-block containing one column of memory cells of each plane; the DRAM further comprising: a plurality of bit lines, wherein each bit line extends along the third axis in one of the planes and is connected to one column of memory cells in that plane, or wherein each bit line extends in one of the planes along the second axis and is connected to one memory cell in each sub-block; a plurality of global bit lines, wherein the global bit lines are connected to the bit lines in each sub-block; and a plurality of sense amplifiers, wherein each sense amplifier is connected to one of the global bit lines.

The DRAM with its 3D array of memory cells is a 3D DRAM. The 3D DRAM may block-addressable, and may even sub-block-addressable. This can be beneficial for its performance, endurance, and energy efficiency, and also the storage density may be increased.

In the DRAM of the first aspect, the connection of the vertical bit lines to the global bit lines reduces the area consumption, due to a more relaxed placement and routing of the sense amplifiers. Additionally, a parasitic bit line loading can be reduced in the 3D DRAM of the first aspect.

In an implementation, the DRAM further comprises a plurality of word lines, wherein each word line extends along the first axis in one of the sub-blocks and is connected to one memory cell in each plane.

The DRAM of the first aspect comprises so-called vertical bit lines, as they extend along the first axis, which is considered the vertical axis in this disclosure.

In an implementation, the DRAM further comprises a single word line driver shared among all the word lines of the block; or multiple word line drivers, wherein each word line driver is shared among all the word lines of one sub-block.

In this way, the number of word line drivers may be reduced. This may lead to a reduction of the area consumed by word line drivers as well.

In an implementation, the DRAM further comprises one or more word line selectors configured to selectively connect the one or more word line drivers to the word lines; wherein each word line selector comprises a plurality of global word lines, and each global word line is connected to a group of word lines.

In an implementation, each group of word lines comprises word lines that are arranged sequentially along the third axis; or each group of word lines comprises word lines that are arranged sequentially along the second axis; or each group of word lines comprises word lines that are arranged interleaved along the second axis; or each group of word lines comprises word lines that are arranged interleaved along the third axis.

In an implementation, the DRAM further comprises: a single word line selector shared among all the word lines; or multiple word line selectors, wherein each word line selector is shared among all the word lines of one sub-block; wherein the one or more word line selectors are configured to selectively connect an output of an address decoder to a plurality of word line drivers; and wherein the plurality of word line drivers are connected to the plurality of word lines.

In this way, the number of word line selectors may be reduced. This may lead to a reduction of the area consumed by word line selectors as well. In this implementation, the one or more word line selectors are arranged and connected between the address decoder and the word line drivers. The address decoder may function as a first decoder, and the one or more word line selectors may function as a second decoder. The address decoder may be an address decoder used in a conventional DRAM. The address decoder maybe a circuit that interprets memory addresses received, for example, form a central processing unit (CPU) to select where data is to be read or written in the memory array. The word line drivers could be inverters, for instance.

In an implementation, if the bit lines extend along the third axis, each global bit line extends in one of the planes along the second axis.

In an implementation, each global bit line is connected to one bit line in each sub-block of the block.

In an implementation, each global bit line is connected to one bit line in each sub-block of a group of sub-blocks associated with the global bit line, and wherein different global bit lines are associated with different groups of sub-blocks.

In an implementation, each group of sub-blocks comprises sub-blocks that are arranged sequentially along the second axis.

In an implementation, each group of sub-blocks comprises sub-blocks that are arranged interleaved along the second axis.

In an implementation, if the bit lines extend along the second axis, each global bit line extends in one of the planes along the third axis.

In an implementation, each global bit line is connected to all bit lines in the one of the planes in each sub-block of the block.

In an implementation, each global bit line is connected to a group of bit-lines in the one of the planes in each sub-block of the block, and wherein different global bit lines are associated with different groups of bit lines.

In an implementation, each group of bit lines comprises bit lines that are arranged sequentially along the third axis.

In an implementation, group of bit lines comprises bit lines that are arranged interleaved along the third axis.

In summary of the above, this disclosure focuses on a vertical word line based 3D DRAM architecture, i.e., the bit lines are extending either along the second axis or the third axis, while the word lines extend along the first axis. The disclosure is concerned with the core architecture of the memory cell array, but also considers a connection between the bit lines and the sense amplifiers, as well as a connection between the word lines and the word line driver(s). The proposed configuration allows reducing the number of sense amplifiers and the number of word line drivers, and thus leads to a reduction of area consumed. Moreover, parasitic loadings, particularly on the bit lines, can be minimized. Additionally, the number of planes of the 3D DRAM may be increased with minimized impact on the parasitic loadings and the area consumption.

### BRIEF DESCRIPTION OF THE DRAWINGS

The above described aspects and implementations are explained in the following description of embodiments with respect to the enclosed drawings:
- FIG. 1: shows perspective views of implementations of a DRAM according to this disclosure.
- FIG. 2: shows a top view of the DRAM according to this disclosure with vertical word lines.
- FIG. 3: shows a perspective view of a first example of a DRAM according to this disclosure.
- FIG. 4: shows a perspective view of a second example of a DRAM according to this disclosure.
- FIG. 5: shows a top view of the DRAM of the first example.
- FIG. 6: shows a top view of the DRAM of the second example.
- FIG. 7: shows a perspective view of a third example of a DRAM according to this disclosure.
- FIG. 8: shows a top view of the DRAM of the third example.
- FIG. 9: shows a perspective view of a fourth example of a DRAM according to this disclosure.
- FIG. 10: shows a top view of the DRAM of the fourth example.
- FIG. 11: shows a perspective view of a fifth example of a DRAM according to this disclosure.
- FIG. 12: shows a perspective view of a sixth example of a DRAM according to this disclosure.
- FIG. 13: shows a top view of the DRAM of the fifth example.
- FIG. 14: shows a top view of the DRAM of the sixth example.
- FIG. 15: shows a perspective view of an eighth example of a DRAM according to this disclosure.
- FIG. 16: shows a top view of the DRAM of the eighth example.
- FIG. 17: shows a perspective view of a ninth example of a DRAM according to this disclosure.
- FIG. 18: shows a top view of the DRAM of the ninth example.
- FIG. 19: shows two exemplary schemes for the word line selector and the bit line selector in a DRAM according to this disclosure.

### DETAILED DESCRIPTION OF EMBODIMENTS

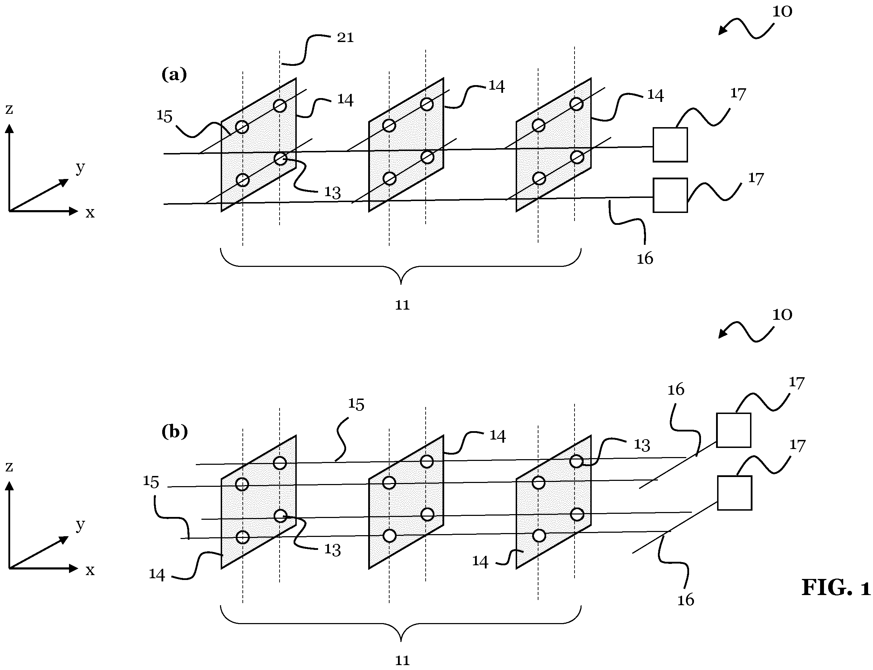

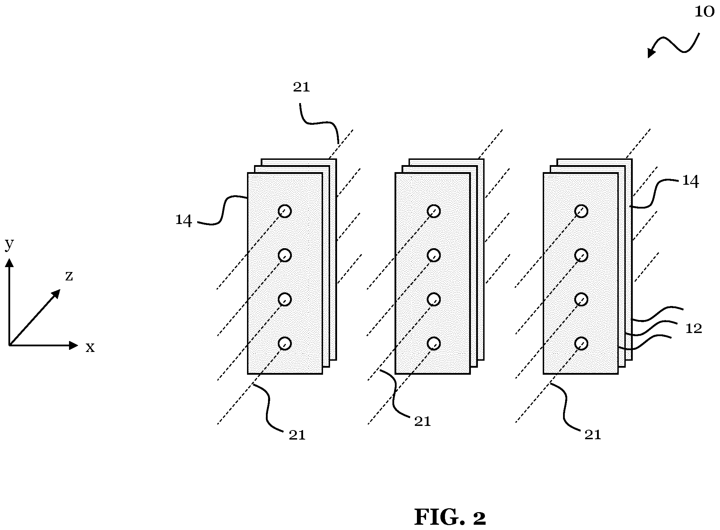

FIG. 1 shows a DRAM 10 according to this disclosure. In particular, FIG. 1(a) shows a perspective view of a first implementation of the DRAM 10, while FIG. 1(b) shows a perspective view of a second implementation of the DRAM 10. FIG. 2 shows a tow-view of parts of the DRAM 10 of either the first or the second implementation.

The DRAM 10 is a 3D DRAM, as it comprises a block 11 including a 3D array of memory cells 13. The DRAM 10 may comprise more than one such block 11, i.e., may be arranged of multiple blocks 11, which may be individually addressable. The memory cells 13 may each comprise a storage capacitor to store data in the form of charge, and a transistor connected to the storage capacitor and configured to enable writing of data to the storage capacitor or reading data from the storage capacitor. Each memory cell 13 may be able to store one bit of data (information). The memory cells 13 in the 3D DRAM 10 may be arranged in rows, columns, and stacks.

In particular, as shown in FIG. 2, the block 11 comprises multiple planes 12, which are stacked along a first axis (the vertical axis in this disclosure, which is the z-axis according to the coordinate system shown in FIG. 1 and 2). Each plane 12 comprises a 2D array of memory cells 13, which are organized in rows extending along a second axis perpendicular to the first axis (the second axis is the x-axis in the coordinate system) and columns extending along a third axis perpendicular to the first and the second axis (the third axis is the y-axis in the coordinate system). The stacked planes 12 accordingly include columns, rows, and stacks of memory cells 13, wherein stacks of memory cells 13 comprise memory cells 13 arranged along the first axis.

As further schematically shown in FIG. 1(a) and 1(b), the block 11 is divided into multiple sub-blocks 14, which are arranged along the second axis. Each sub-block 14 contains one column of memory cells 13 of each plane 12. The consecutive arrangement of the sub-blocks 14 defines the rows of memory cells 13 along the second axis. Each sub-block 14 may be individually addressable in the DRAM 10.

The DRAM 10 also comprises a plurality of bit lines 15. Each bit line 15 extends either along the third axis in one of the planes 12 and is connected to one column of memory cells 13 in that plane 12 (implementation of FIG. 1(a)), or extends in one of the planes 12 along the second axis and is connected to one memory cell 13 in each sub-block 14 of the block 11 (implementation of FIG. 1(b)).

Moreover, the DRAM 10 includes a plurality of global bit lines 16. The global bit lines 16 are connected to the bit lines 15 in each sub-block 14. In FIG. 1(a), each global bit line 16 extends in one of the planes 12 along the second axis, and each global bit line 16 is connected to one bit line 15 in each of two or more or all sub-blocks 14 of the block 11. In FIG. 1(b), each global bit line 16 extends in one of the planes 12 along the third axis, and each global bit line 16 may be connected to two or more or all bit lines 15 in the one of the planes 12 in each sub-block 14 of the block 11.

As shown further in FIG. 1(a) and FIG. 1(b), the DRAM 10 also comprises a plurality of sense amplifiers 17. Each sense amplifier 17 is connected to one of the global bit lines 16, and is configured to sense (detect) a charge on that global bit line 16. Indirectly, each sense amplifier 17 may thus be connected to - via said global bit line 16 - multiple bit lines 15, and may thus be able to detect charge coming from at least one bit line 15 onto the global bit line 16. It may be possible in the DRAM 10 to read charge of a single memory cell 13 per sub-block 14 using the bit line 15, global bit line 16, and sense amplifier 17.

FIG. 2 shows that the DRAM 10 further comprises a plurality of word lines 21. Each word line 21 extends in one of the sub-blocks 14 along the first axis. The word lines 21 are thus referred to as vertical word lines in this disclosure. Each word line 21 is connected to one memory cell 13 in each plane 12. That is, each word line 21 is connected to one stack of memory cells 13. If a word line 21 is operated (charged), the memory cells 13 connected to the word line 21 may be activated. For instance, the transistor connected to the storage capacitor of the memory cell 13 may be turned on, in order to allow charge to be written to or read from the storage capacitor. Reading and writing may be conducted via the bit line 15 connected to this activated memory cell 13.

In the following, more specific examples of the DRAM 10 according to this disclosure are presented. These examples are all based on the DRAM 10 shown in FIG. 1 and FIG. 2. Same elements in FIG. 1, FIG. 2, and any one of the following figures share the same reference signs, and may be implemented and/or function likewise. Redundant description is avoided.

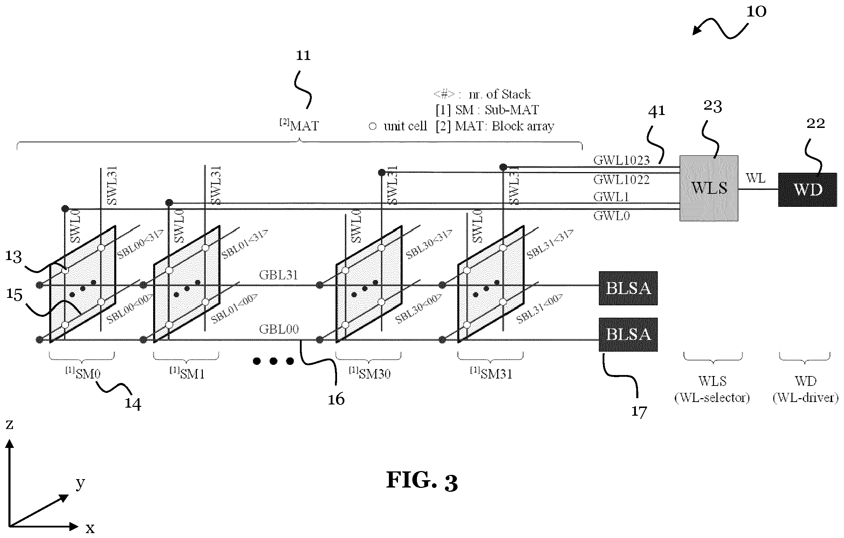

FIG. 3 shows a perspective view of a first example of a DRAM 10 according to this disclosure. In the DRAM 10 of FIG. 3, the block 11 is called a "MAT", and the multiple sub-blocks 14 are respectively called "Sub-MAT" or short "SM". The sub-blocks 14 are numbered SM0 to SM31. Accordingly, each block 11 is composed of 32 sub-blocks 14 in this example.

FIG. 3 shows further that each bit line 15 extends in one of the planes 12 along the third axis. Thereby, each bit line 15 is connected to one column of memory cells 13 in the plane 12 it extends. In total, in this example, there are 32 bit lines 15 for each of the exemplary 32 planes. The bit lines 15 are called and numbered SBL00<00> to SBL00<31> to SBL31<00> to SBL31<31>, wherein <#> denotes the particular plane 12 with number # of the 32 planes 12. Moreover, each sub-block 14 comprises 32 vertical word lines 21 in this example, which extend along the first axis, and which are called and numbered SWL0 to SWL31 in respectively each sub block 14.

In order to improve the connection between the bit lines 15 and the sense amplifiers 17 (e.g., the BLSAs shown in FIG. 3) in this example - while taking into account the smaller BLP - each bit line 15 in each sub-block 14 is connected to one global bit line 16. Each of the global bit lines 16 extends along the second axis in this example, and is connected to one bit line in every sub-block 14 of the block 11. The global bit lines 16 are called and numbered GBL00 to GBL31 in this example. Each global bit line 16 is connected to one sense amplifier 17. The sense amplifiers 17 are located at the right (or left) side of the array, i.e., are placed offset along the second axis from the memory cell array formed by the sub-blocks 14. Thus, a global bit line 16 can be common to all sub-blocks 14.

FIG. 3 also shows that the 3D DRAM 10 has, in addition to the 3D memory cell array, a word line driver 22, and a word line selector 23. The word line driver 22 is located at the right (or left) side of the array, i.e., it is offset along the second axis from the memory cell array formed by the sub-blocks 14. The word line driver 22 is shared among all the word lines 21 of the block 11 in this example. The word line selector 23 is configured to selectively connect the word line driver 22 to the word lines 21. The word lines selector 23 allows selecting one word line 21 out of all the word lines 21 in the block 11. Since only one word line 21 is activated in the block 11 at a time, the word line driver 22 can be shared among all the word lines 21. In this example, the configuration is a per block level common word line driver 22.

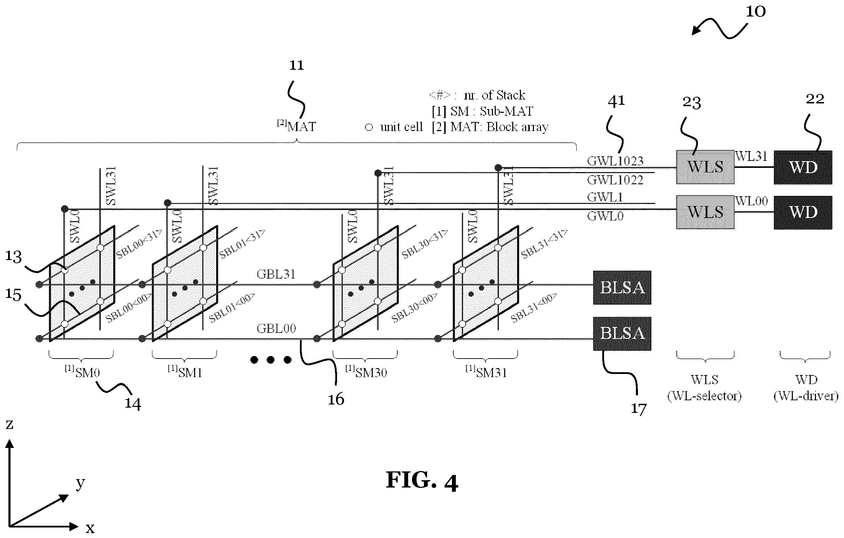

FIG. 4 shows a perspective view of a second example of a DRAM 10 according to this disclosure. The DRAM 10 of FIG. 4 is very similar to that of FIG. 3. In contrast to FIG. 3, the DRAM 10 of FIG. 4 comprises a plurality of word line drivers 22 (only two "WD" are shown), and a plurality of word line selectors 23 (only two "WLS" are shown). The word line drivers 22 are located at the right (or left) side of the array, i.e., they are offset along the second axis from the memory cell array formed by the sub-blocks 14. Each word line driver 22 is associated with one of the sub-blocks 14, wherein each word line driver 22 is connected to the word lines 21 of the sub-block 14. Thus, there may be 32 word line drivers 22 in this example. The multiple word line selectors 23 are configured to selectively connect the word line drivers 22 to the word lines 21. The word lines selectors 23 allow selecting one word line 21 out of all the word lines 21 in any sub-block 14.

The word line driver(s) 22 in FIG. 3 and FIG. 4 may be connected to an address decoder of the DRAM 10, i.e., they may be arranged and connected between the one or more word line selectors 23 and the address decoder. This configuration could also be swapped, i.e., one or more word line selectors 23 could be arranged and connected between the address decoder and a plurality of word line drivers 22, wherein the word line drivers 22 are connected to the word lines 21.

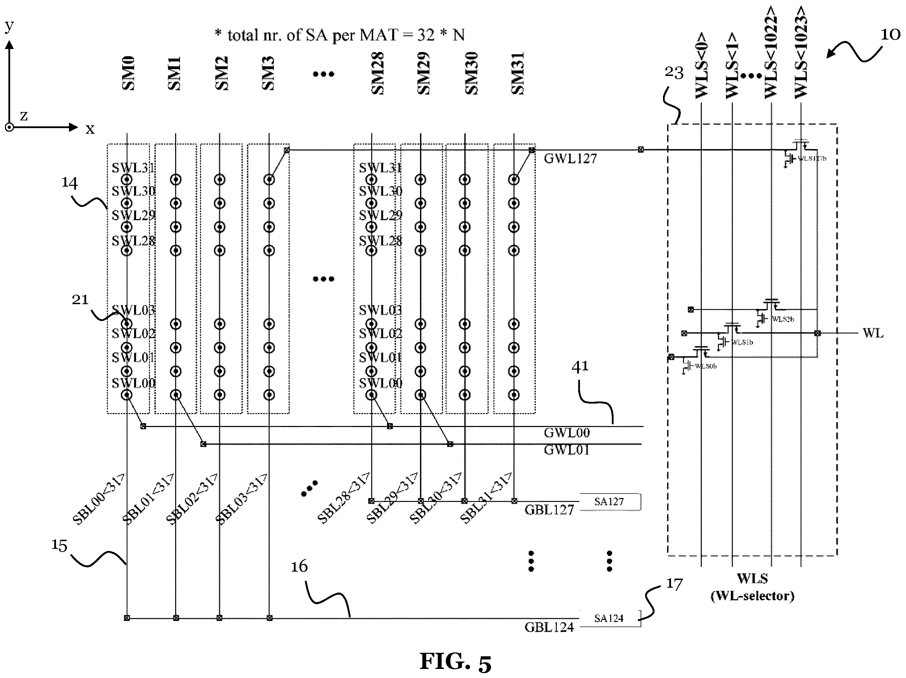

FIG. 5 shows a top view of the DRAM 10 of the first example. In particular, FIG. 5 shows only one plane 12 of the plurality of planes 12 of the DRAM 10. FIG. 5 shows how the bit lines 15 are connected, on the one hand, to the memory cells 13 of the 2D array of that plane 12 and, on the other hand, to the global bit lines 16. FIG. 5 also shows how the word lines 21 are connected, on the one hand, to the memory cells 13 of the 2D array of that plane 12 and, on the other hand, to the word line selector 23.

The word line selector 23 may comprise a plurality of global word lines 41 to connect to the word lines 21 of the block 11. Each of these global word lines 41 may specifically be connected to one word line 21. That is, each global word line 41 may be connected to one of the 32 word lines 21 of one of the 32 sub-blocks 14 of the block 11, so that there are 32×32 global word lines 41 labelled GWLoo to GWL1023 in this example.

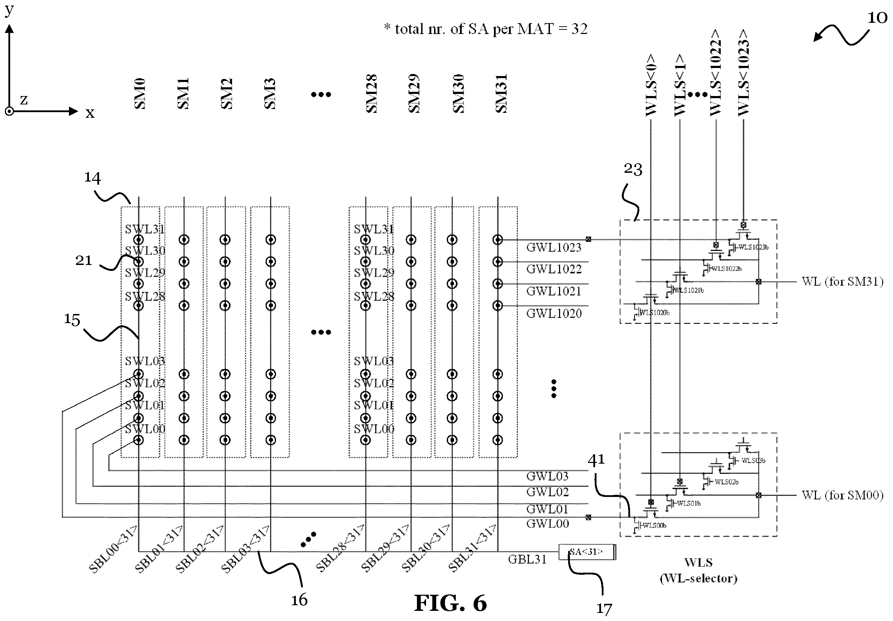

FIG. 6 shows a top view of the DRAM 10 of the second example. In particular, FIG. 6 shows, similar to FIG. 5, only one plane 12 of the plurality of planes 12 of the DRAM 10. In FIG. 6 there are the multiple word line selectors 23, which respectively comprise a plurality of global word lines 41. Like in FIG. 5, each global word line 41 is connected to one word line 21 in one sub-block 14 of the block. In particular, there is one word line selector 23 associated with each sub-block 14 of the block 11.

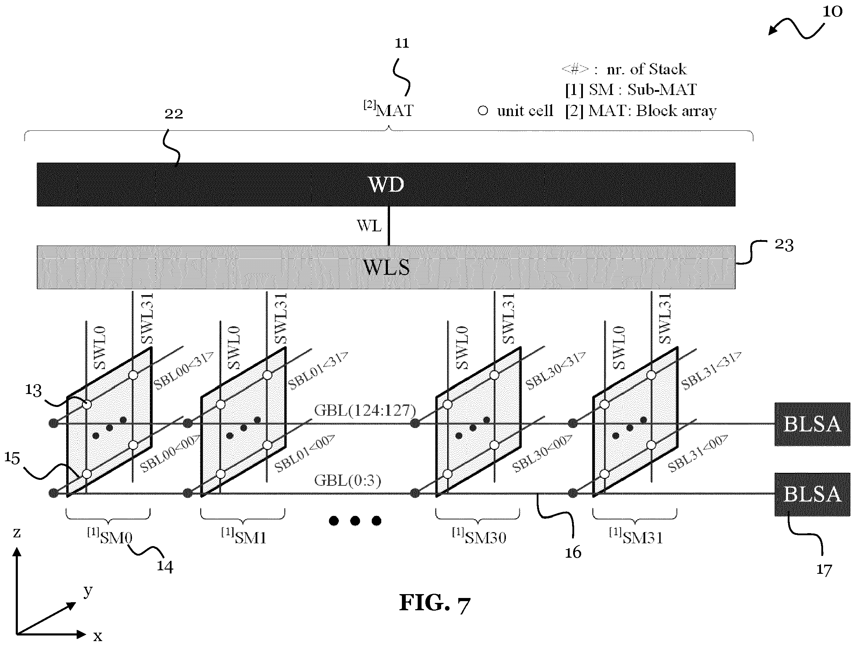

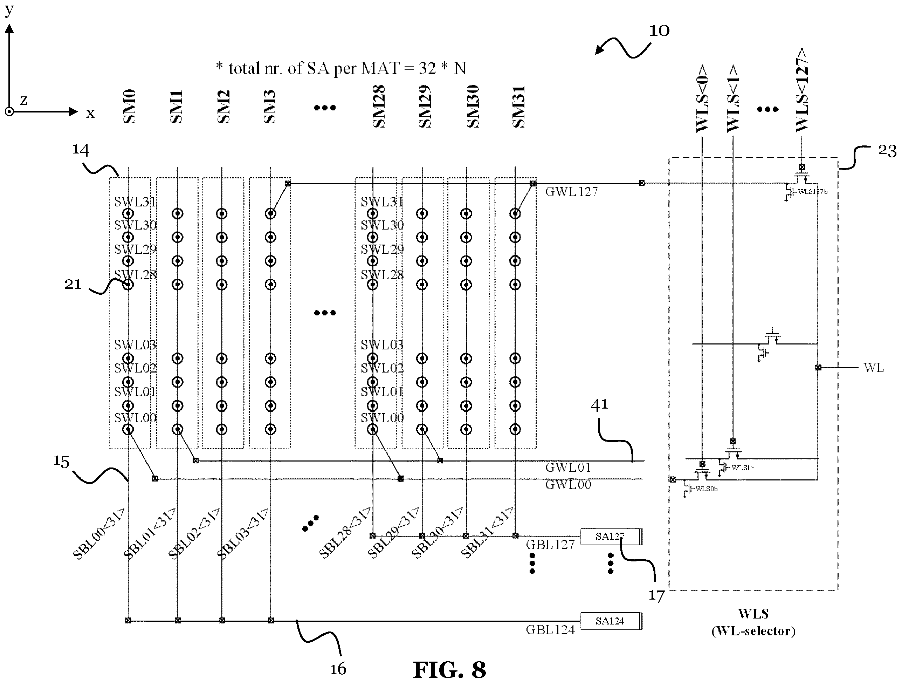

FIG. 7 shows a perspective view of a third example of a DRAM 10 according to this disclosure. FIG. 8 shows a top view of the DRAM 10 of the third example. In this third example, each global bit line 16 extends along the second axis, like in FIG. 3 and FIG. 4.

However, FIG. 7 and 8 show a 3D DRAM memory architecture, wherein each single global bit line 16 of FIG. 3 is divided into multiple (here particularly four) global bit lines 16 per plane 12. That is, each plane 12 is now associated with a respective group of global bit lines 16 (e.g., the group GBL124 to GBL127 for the top most plane <31> shown in FIG. 8). This division may increase the number of data queues and may reduce the parasitic loadings on the global bit lines 16.

The connection between the bit lines 15 and the multiple global bit lines 16 in the plane 12 may be interleaved along the second axis, or sequential like in the case of FIG. 7 and 8. In this sequential connection case, consecutively arranged bit lines 15 are connected to the same global bit line 16. While each bit line 15 is connected to one global bit line 16, each global bit line 16 is connected in this case to a bit line 15 in each sub-block 14 of a group of sub-blocks 14, wherein the sub-block 14 is associated with that global bit line 16. Different global bit lines 16 are associated with different groups of sub-blocks 14. For instance, as shown in FIG. 8 for the plane <31>, GBL124 is connected to SBL00<31> in SM0, to SBL01<31> in SM1, to SBL02<31> in SM2, and to SBL03<31> in SM3, wherein these bit lines 15 and sub-blocks are consecutively arranged along the second axis, respectively. The GBL127 is connected to SBL28<31> in SM28, to SBL29<31> in SM29, to SBL30<31> in SM30, and to SBL31<31> in SM31. These bit lines 15 and sub-blocks 14 are also consecutively arranged along the second axis.

The same arrangements - i.e., sequential or interleaved - can be followed for the connection between the word lines 21 and word line selector 23. This third example comprises a sequential bit line (explained above) and an interleaved word line arrangement. In particular, as can also be seen in FIG. 8, each global word line 41 of the word line selector 23 is connected to a group of word lines 21. Each group of word lines 21 comprises word lines 21 that are arranged interleaved along the second axis in this case. For example, GWLoo is connected to SWL00 in SM0 and to SWL00 in SM28, while GWL127 is connected to SWL31 in SM3 and SWL31 in SM31 in the plane that is shown.

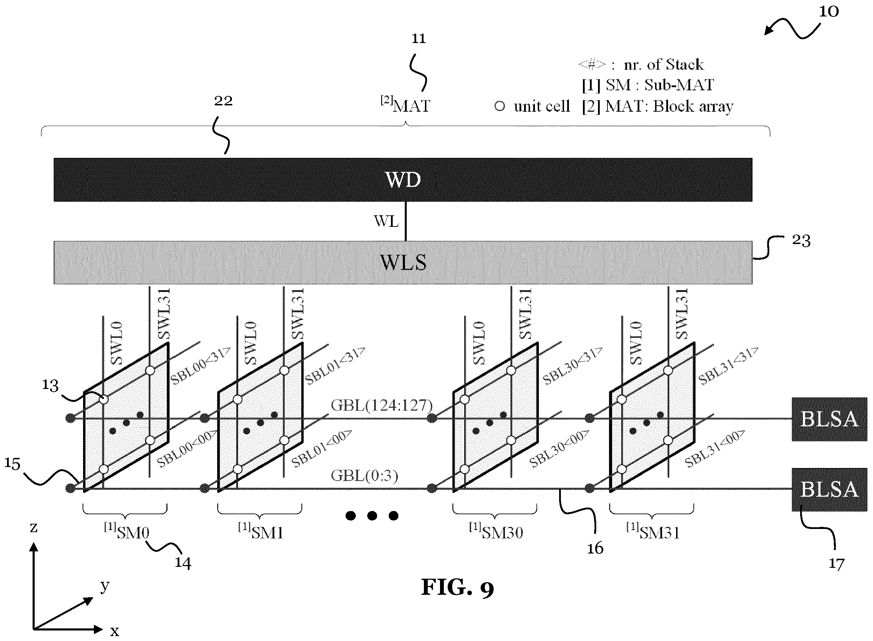

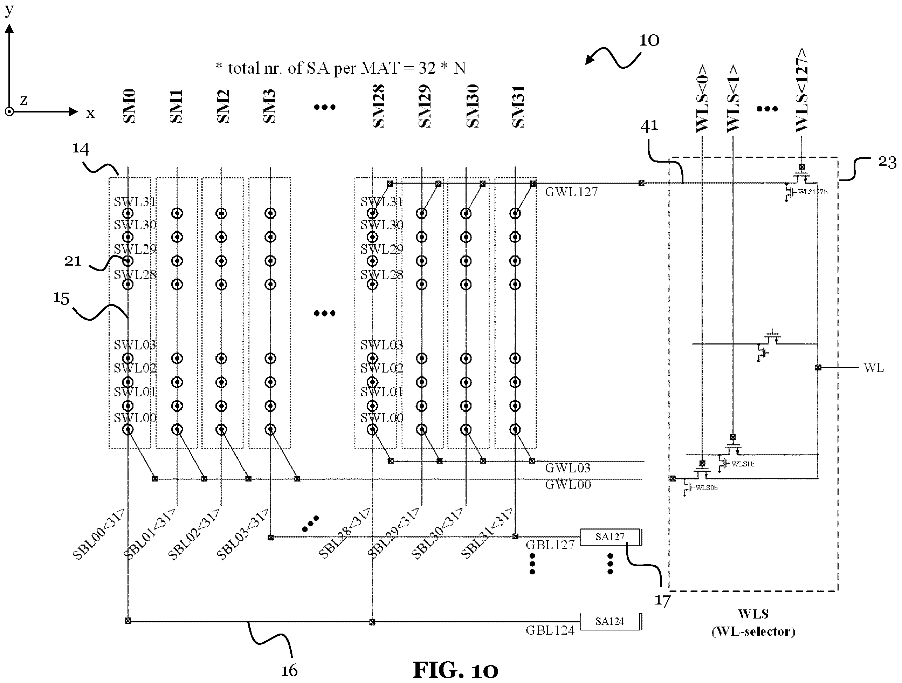

FIG. 9 shows a perspective view of a fourth example of a DRAM 10 according to this disclosure. FIG. 10 shows a top view of the DRAM 10 of the fourth example. In this fourth example, each global bit line 16 extends along the second axis, like in FIG. 3 and FIG. 4. Like in FIG. 7 and 8 each global bit line 16 is connected to one bit line 15 in each sub-block 14 of a group of sub-blocks 14 that is associated with the global bit line 16. Different global bit lines 16 are associated with different groups of sub-blocks 14. Unlike in FIG. 7 and 8, however, in the fourth example each group of sub-blocks 14 comprises sub-blocks 14 that are arranged interleaved along the second axis.

For example, as shown in FIG. 10, GBL124 is associated with the sub-blocks SM0 and SM28, where it is connected to SBL00<31> and SBL28<31>. These bit lines 15 and sub-blocks 14 are not consecutively arranged along the second axis. Further, GBL127 is connected to SBL03<31> in SM3 and to SBL31<31> in SM31. These bit lines 15 and sub-blocks 14 are also not consecutively arranged along the second axis, so that an interleaved connection is established along the second axis.

As can also be seen in FIG. 10, each global word line 41 of the word line selector 23 is connected to a group of word lines 21. Each group of word lines 21 comprises word lines 21 that are arranged sequentially along the second axis in this case. For example, GWLoo is connected to SWL00 in SM0, SM1, SM2 and SM3, while GWL03 is connected to SWL00 in SM28, SM29, SM30 and SM31 of the plane that is show. These word lines 21 and sub-blocks 14 are arrange sequentially along the second axis.

That is, in this fourth example, there is an interleaving connection between bit lines 15 and the global bit lines 16. That is, a mixing of the bit lines 15 is possible for the same global bit line 16. Further, the word lines 21 are connected sequentially to the global word lines 41. This example thus comprises an interleaved bit line and a sequential word line arrangement.

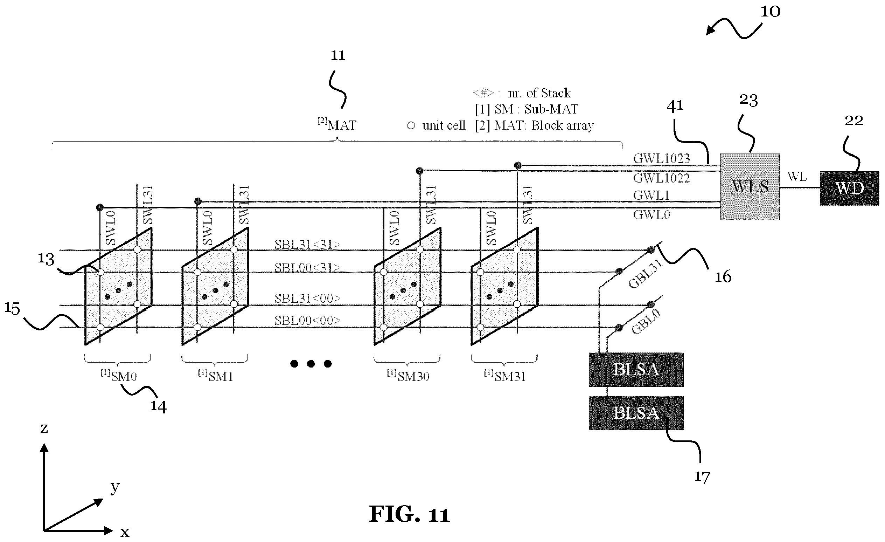

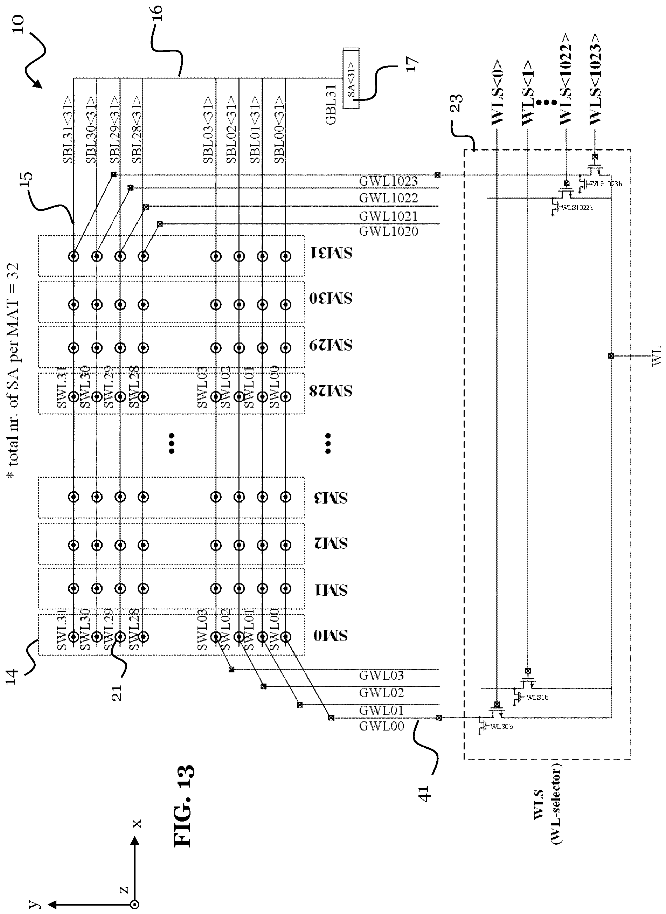

FIG. 11 shows a perspective view of a fifth example of a DRAM 10 according to this disclosure. FIG. 13 shows a top view of the DRAM 10 of the fifth example. In the fifth example, each bit line 15 extends in one of the planes 12 along the second axis and is connected to one memory cell 13 in each sub-block 14. Each global bit line 16 extends in one of the planes 12 along the third axis. Each global bit line 16 is connected to all bit lines 15 in the plane 12, which it extends in. For example, GBL31 is connected to SBL00<31> to SBL31<31> of the plane <31>. Further, each global bit line 16 is connected to one sense amplifier 17, for example, GBL31 is connected to SA<31>.

As also shown, the DRAM 10 comprises the plurality of word lines 21, each extending in one of the sub-blocks 14 along the first axis, and each being connected to one memory cells 13 of each plane 12. Each sub-block 14 accordingly comprises multiple word lines 21, one for each memory cell 13 in a column of memory cells 13. Thus, each sub-block 14 may comprise 32 word lines 21 as shown.

Further, the DRAM 10 of FIG. 11 and 13 comprises one word line driver 22, wherein the word line driver 22 is shared among all the word lines 21 of the block 11, like in FIG. 3. The word line driver 22 maybe located at the right (or left) side of the array, i.e., it may be offset along the second axis from the memory cell array formed by the sub-blocks 14. The DRAM 10 also comprises one word line selector 23, which is configured to selectively connect the word line driver 22 to the word lines 21.

Unlike in FIG. 3, the sense amplifiers 17 are located in front of or behind the memory cell array, i.e., they are offset along the third axis from the sub-blocks 14, as the global bit lines 16 extend along the third axis.

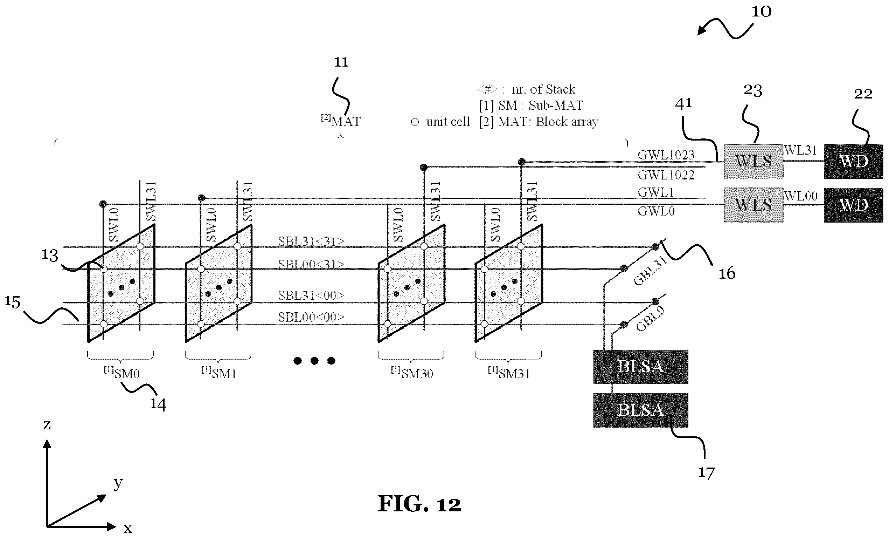

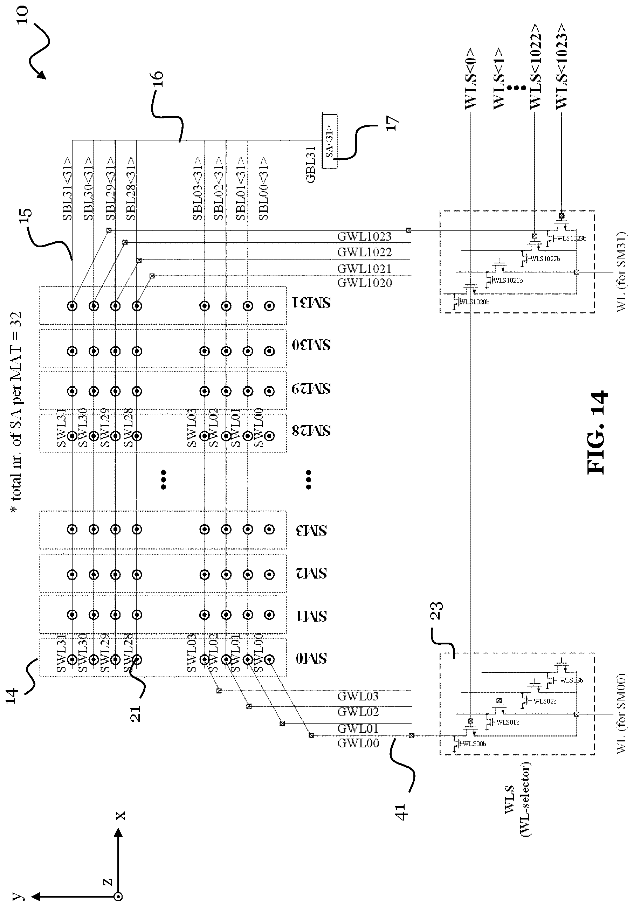

FIG. 12 shows a perspective view of a sixth example of a DRAM 10 according to this disclosure. FIG. 14 shows a top view of the DRAM 10 of the sixth example. The DRAM 10 of the sixth example is very similar to the DRAM 10 of the fifth example, however, the DRAM 10 of FIG. 12 and 14 comprises multiple word line drivers 22 and multiple word line selectors 23, similarly as shown in FIG. 4. The word line driver placement may be per sub-block 14 of the DRAM 10.

The word line selector(s) 23 in FIG. 13 and 14 respectively comprise a plurality of global word lines 41, wherein each global word line 41 is connected to one word line 21 in the block 11, similar to what is described above with respect to FIG. 5 and 6. For example, GWLoo may be connected to SWL00 in SM0, and GWL1023 may be connected to SWL31 in SM31.

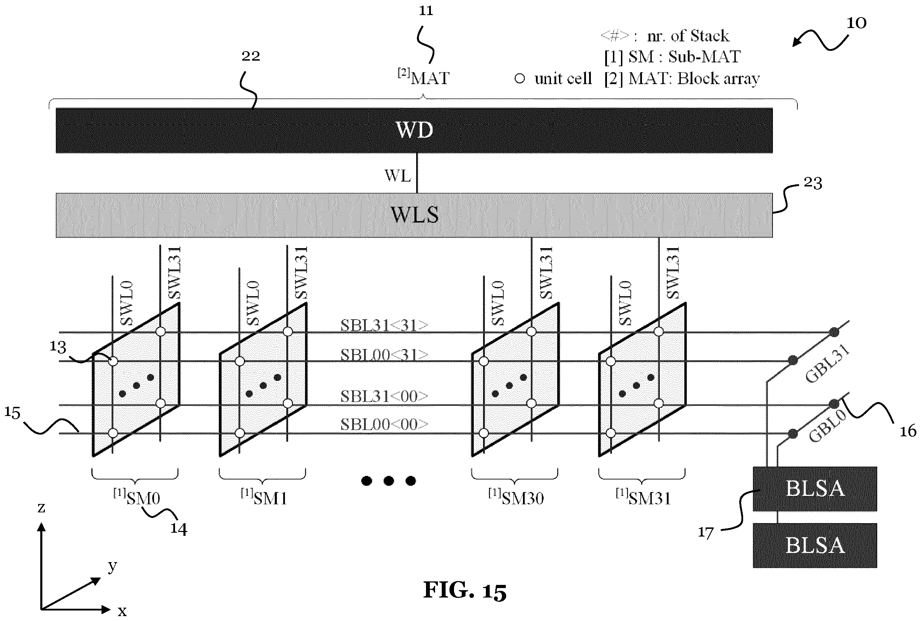

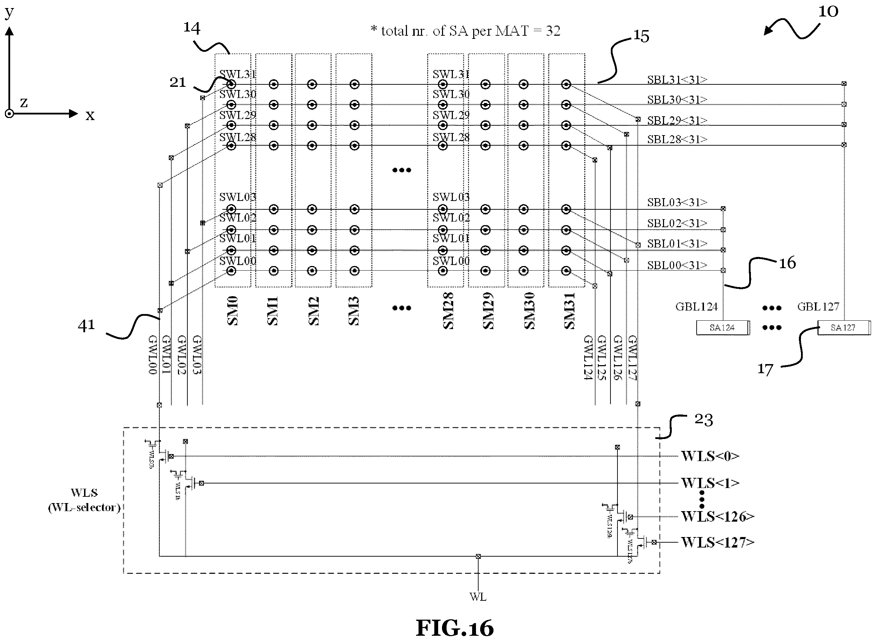

FIG. 15 shows a perspective view of an eighth example of a DRAM 10 according to this disclosure. FIG. 16 shows a top view of the DRAM 10 of the eighth example. In the eight example, each global bit line 16 extends along the third axis.

However, FIG. 15 and 16 show a 3D DRAM memory architecture, wherein each global bit line 16 of FIG. 13 is divided into multiple (here particularly four) global bit lines 16 per plane 12. That is, each plane 12 is associated with a respective group of global bit lines 16 (e.g., the group GBL124 to GBL127 for the top most plane <31> shown in FIG. 16). This may increase the number of data queues and may reduce the parasitic loadings on the global bit lines 16.

The connection between the bit lines 15 and the multiple global bit lines 16 in the plane 12 may be interleaved along the third axis, or sequential like in this case. In the sequential connection case, consecutively arranged bit lines 15 are connected to the same global bit line 16. While each bit line 15 is connected to one global bit line 16, each global bit line 16 is connected in this to a group of bit lines 15 (in one of the planes 12) in each sub-block 14. This stands in contrast to previous examples wherein each global bit line 16 is connected to one bit line 15. Different global bit lines 16 are associated with different groups of bit lines 15. For instance, as shown in FIG. 16 for the plane <31>, GBL124 is connected to SBL00<31>, SBL01<31>, SBL02<31>, and SBL03<31> in SM31, wherein these bit lines 15 are consecutively arranged along the third axis. The GBL127 is connected to SBL28<31> to SBL31<31> in SM31, which are also consecutively arranged along the third axis.

The same arrangements - i.e., sequential or interleaved - can be followed for the connection between the word lines 21 and the word line selector 23. This eighth example comprises a sequential bit line (explained above) and an interleaved word line arrangement. In particular, as can also be seen in FIG. 16, each global word line 41 of the word line selector 23 is connected to a group of word lines 21. Each group of word lines 21 comprises word lines 21 that are arranged interleaved along the third axis in this case. For example, GWLoo is connected to SWL00 and SWL28 in SM0, while GWL01 is connected to SWL01 and SWL29 in SM0, and so forth.

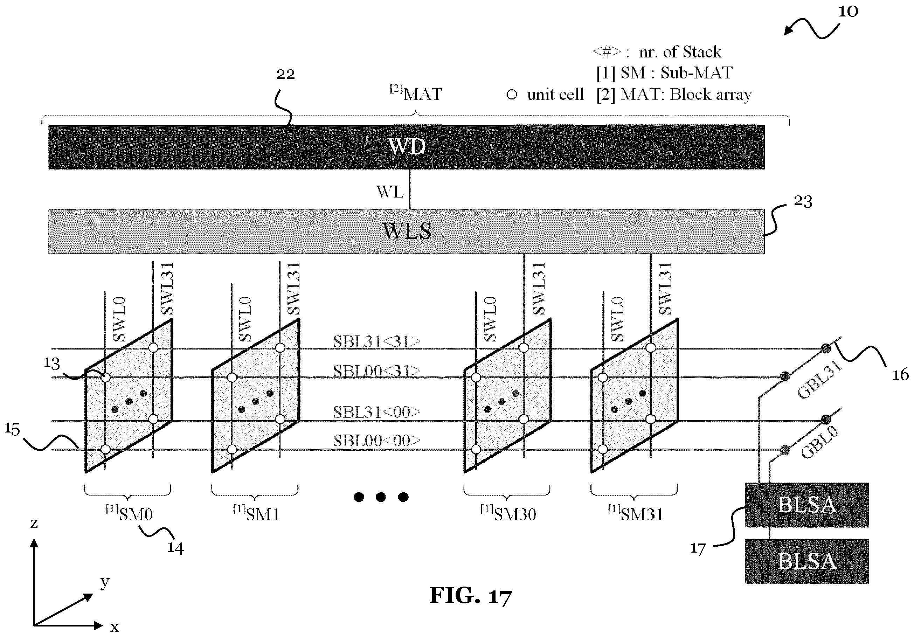

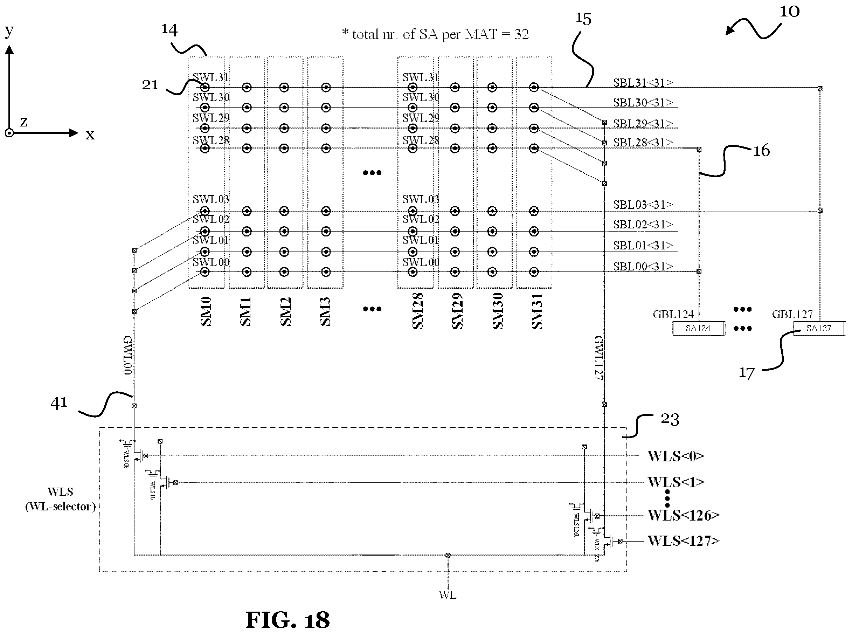

FIG. 17 shows a perspective view of a ninth example of a DRAM 10 according to this disclosure. FIG. 18 shows a top view of the DRAM 10 of the ninth example. The ninth example is very similar to the eight example. However, as can be seen in FIG. 18, each group of bit lines 15 comprises bit lines 15 that are arranged interleaved along the third axis. For example, GBL124 is connected to SBL00<31> and SBL28<31> in SM31, while GBL127 is connected to SBL03<31> and SBL31<31> in SM31. These respective bit lines 15 are not arranged consecutively along the third axis, so that an interleaved connection is established along the third axis.

Moreover, the word line selector 23 in the ninth example comprises a plurality of global word lines 41, wherein each global word line 41 is connected to a group of word lines 21. For instance, in FIG. 18, GWLoo is connected to SWL00, SWL01, SWL02 and SWL03 in SM0, while GWL127 is connected to SWL28, SWL29, SWL30, and SWL31 in SM31. That is, each group of word lines 21 comprises word lines 21 that are arranged sequentially along the third axis.

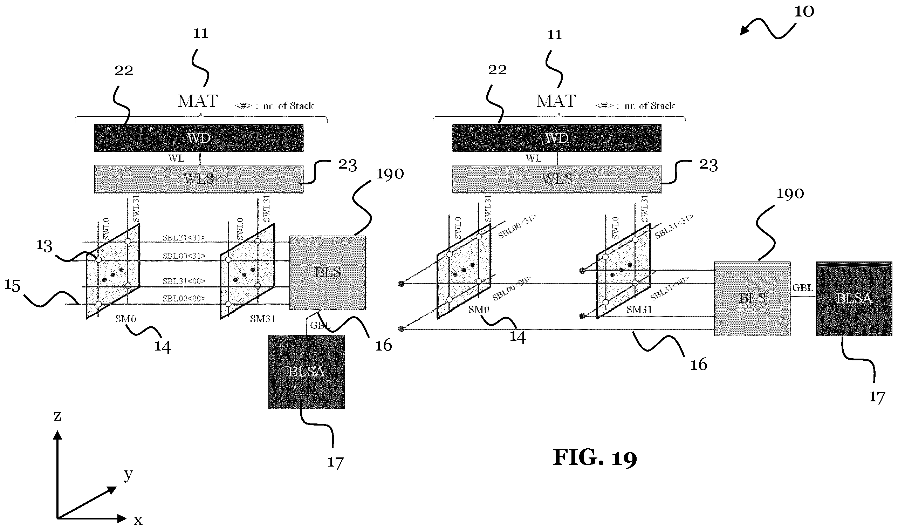

FIG. 19 shows two exemplary schemes for the placement of the word line selector 23 and of a bit line selector 190 in a DRAM 10 according to this disclosure. In FIG. 19(a) and 19(b) the word line selector 23 is arranged offset along the first axis from the memory cell array. In Fig. 19(a) the bit line selector 190 is arranged offset from the memory cell array along the extensions of the bit lines 15 into the second axis. All the bit lines 15 are connected to the bit line selector 190 and can be connected, via the global bit lines 16, to one sense amplifier 17. In FIG. 19(b) the bit line selector 190 is arranged offset from the memory cell array along the second axis and the third axis, and can be connected to all bit lines 15 extending along the third axis in each sub-block 14. The architectures shown in FIG. 19 result in smaller parasitic loading and a smaller area consumption, because of the one sense amplifier 17, and also result in a relaxed global BLP

In summary, this disclosure addresses the challenges that DRAM scaling is facing in terms of memory bit cell area, memory density, and aspect ratio in the vertical direction. The disclosure provides a 3D DRAM 10 that is designed by considering the connections between the memory cells 13 and core circuits, like sense amplifiers 17, word line drivers 22, word line selectors 22, and bit line selectors 190. The disclosure provides a solution for a 1T1C-based 3D DRAM memory cell core, and specifically introduces a way of configuring the 3D DRAM memory cell array and its connection to the sense amplifier(s) 17 and word line driver(s) 22. As a consequence, less area consumption, less parasitic bit line loadings, and less word line drivers 22 can be achieved in the DRAM 10.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A dynamic random access memory, DRAM (10), comprising:
a block (11) comprising a 3D array of memory cells (13);
wherein the block (11) comprises multiple planes (12) stacked along a first axis, each plane (12) comprising a 2D array of memory cells (13) organized in rows extending along a second axis perpendicular to the first axis and columns extending along a third axis perpendicular to the first and the second axis; and
wherein the block (11) is divided into multiple sub-blocks (14) arranged along the second axis, each sub-block (14) containing one column of memory cells (13) of each plane (12);
the DRAM (10) further comprising:
a plurality of bit lines (15), wherein each bit line extends along the third axis in one of the planes (12) and is connected to one column of memory cells (13) in that plane (12), or wherein each bit line (15) extends in one of the planes (12) along the second axis and is connected to one memory cell (13) in each sub-block (14);
a plurality of global bit lines (16), wherein the global bit lines (16) are connected to the bit lines (15) in each sub-block (14); and
a plurality of sense amplifiers (17), wherein each sense amplifier (17) is connected to one of the global bit lines (16).

2. The DRAM (10) of claim 1, further comprising:
a plurality of word lines (21), wherein each word line (21) extends along the first axis in one of the sub-blocks (14) and is connected to one memory cell (13) in each plane (12).

3. The DRAM (10) of claim 2, further comprising:
a single word line driver (22) shared among all the word lines (21) of the block (11); or
multiple word line drivers (22), wherein each word line driver (22) is shared among all the word lines (21) of one sub-block (14).

4. The DRAM (10) of claim 3, further comprising:
one or more word line selectors (23) configured to selectively connect the one or more word line drivers (22) to the word lines (21);
wherein each word line selector (23) comprises a plurality of global word lines (41), and each global word line (41) is connected to a group of word lines (21).

5. The DRAM (10) of claim 4, wherein:
each group of word lines (21) comprises word lines (21) that are arranged sequentially along the third axis; or
each group of word lines (21) comprises word lines (21) that are arranged sequentially along the second axis; or
each group of word lines (21) comprises word lines (21) that are arranged interleaved along the second axis; or
each group of word lines (21) comprises word lines (21) that are arranged interleaved along the third axis.

6. The DRAM (10) of claim 2, further comprising:
a single word line selector (23) shared among all the word lines (21); or
multiple word line selectors (23), wherein each word line selector (23) is shared among all the word lines (21) of one sub-block (14);
wherein the one or more word line selectors (23) are configured to selectively connect an output of an address decoder to a plurality of word line drivers (22); and
wherein the plurality of word line drivers (22) are connected to the plurality of word lines (21).

7. The DRAM (10) of one of the claims 1 to 6, wherein if the bit lines (15) extend along the third axis, each global bit line (16) extends in one of the planes (12) along the second axis.

8. The DRAM (10) of claim 7, wherein each global bit line (16) is connected to one bit line (15) in each sub-block (14) of the block (11).

9. The DRAM (10) of claim 7, wherein each global bit line (16) is connected to one bit line (15) in each sub-block (14) of a group of sub-blocks (14) associated with the global bit line (16), and wherein different global bit lines (16) are associated with different groups of sub-blocks (14).

10. The DRAM (10) of claim 9, wherein each group of sub-blocks (14) comprises sub-blocks (14) that are arranged sequentially along the second axis.

11. The DRAM (10) of claim 9, wherein each group of sub-blocks (14) comprises sub-blocks (14) that are arranged interleaved along the second axis.

12. The DRAM (10) of one of the claims 1 to 6, wherein if the bit lines (15) extend along the second axis, each global bit line (16) extends in one of the planes (12) along the third axis.

13. The DRAM (10) of claim 12 wherein each global bit line (16) is connected to all bit lines (15) in the one of the planes (12) in each sub-block (14) of the block (11).

14. The DRAM (10) of claim 12, wherein each global bit line (16) is connected to a group of bit-lines (15) in the one of the planes (12) in each sub-block (14) of the block (11), and wherein different global bit lines (16) are associated with different groups of bit lines (15).

15. The DRAM (10) of claim 14, wherein each group of bit lines (15) comprises bit lines (15) that are arranged sequentially along the third axis.

16. The DRAM (10) of claim 14, wherein each group of bit lines (15) comprises bit lines (15) that are arranged interleaved along the third axis.
